# EUROPEAN PATENT APPLICATION

(11) **EP 0 782 249 A1**
(43) Date of publication of application: **02.07.1997**
(21) Application number: 96309248.1
(22) Date of filing: 18.12.1996
(51) Int. Cl.: H03D 7/18, H03D 7/16

(54) **System and method for rejecting image signals**

(30) Priority: 26.12.1995 US 591190
(71) Applicant: Lucent Technologies Inc., Murray Hill, New Jersey 07974-0636 (US)
(72) Inventor: Banu, Mihai, Murray Hill, New Jersey 07974 (US); Dec, Alex, New York, New York 10025 (US); Glas, Jack, 2623 ME Delft (NL); Seidel, Mark N., New Providence, New Jersey 07974 (US); Tarsia, Maurice J., Colonia, New Jersey 07067 (US); Wang, Hongmo, Watchung, New Jersey 07060 (US)
(74) Representative: Buckley, Christopher Simon Thirsk

(57) **Abstract**

A method and apparatus process an input signal along two paths so as to reject image signals created during processing. On the first path (A,E,F,D₂) the input signal is mixed (in 647) with a first component (from 606) of a first local oscillator (605) signal to generate a first signal at a first, non-zero intermediate frequency, the first signal is filtered, (in 664), and the filtered first signal and a first component (from 618) of a second local oscillator (619) signal are mixed (in 667) to generate a second signal at a second intermediate frequency, wherein the second intermediate frequency is higher than the first intermediate frequency. On the second path (A,B,C,D₁ ) the input signal is mixed (in 607) with a second component (from 606) of the first local oscillator (605) signal to generate a third signal at the first intermediate frequency, the third signal is filtered (in 614), and the filtered third signal and a second component (from 618) of the second local oscillator (619) signal are mixed (in 617) to generate a fourth signal at the second intermediate frequency. An output signal is generated (by 630) as a function of the fourth signal and the second signal in which output signal the image signals have been reduced.

## Description

### Technical Field

The invention relates to the field of methods and equipment for receiving signals transmitted over a path.

### Background

The tremendous growth experienced by wireless communication systems, as for example by cellular systems, in the past few years has transformed wireless communications from a specialized service for a select few individuals into a service available to many. The cellular systems concept calls for dividing a geographic area into a number of cells. Each cell advantageously has an associated cell site (also called a base station) which is connected via a wireless switching center to a wired phone network. The cell site establishes a wireless link over radio frequency (*i.e.,* frequencies above 20,000 Hz) paths with wireless terminals (*e.g.,* cellular phones) operated by subscribers to the system within the cell. Subscribers are then able to use their wireless terminals to send and receive information to and from other wireless terminals and to and from devices connected to the telephone network.

The growth in the number of subscribers has placed a strain on cellular systems in many areas, making it increasingly difficult to operate and maintain the quality and reliability of such systems. As a consequence, organizations, such as the Telecommunications Industry Association, are drafting standards (*e.g.,* the pan-European Global System for Mobile Communications Standard (GSM) and the IS-54 Standard) to meet the increased demands on cellular systems. To increase the capacity of cellular systems, these standards will typically reduce the power at which cellular signals are transmitted (and consequently received). Reduced transmitter power will allow greater reuse of frequencies in non-adjoining cells (*i.e.,* in cells that are sufficiently far apart in distance so that frequencies common to, or used in, both cells do not interfere with each other). These standards will also more efficiently utilize the spectrum of frequencies assigned for cellular. The increased efficiency will allow a larger number of users to access the system. As a consequence, a received signal of interest must be processed by a receiver in the cellular system so as to output to a subscriber a signal (*e.g.,* a speech signal) of sufficient quality to satisfy subscriber demands. Quality must be maintained both when the received signal of interest is of low power and when the received signal of interest operates in an environment in which other signals, of varying power levels, are received (along with the signal of interest) at the receiver's antenna.

The processing of a received signal of interest in a receiver involves three major operations. The receiver must: 1) amplify, 2) tune and frequency translate, and 3) filter the received signal of interest.

A receiver must first amplify a received signal of interest because the power in the received signal of interest is small, typically on the order of -100 dBm. The power in the received signal of interest is small, not only because the signal as originally transmitted was limited in power in accordance with the drafted standards, but also because the power of a signal will decrease as the signal propagates along or through a radio frequency (RF) link between a transmitting and receiving antenna. The power in a received signal must be amplified so as to distinguish the signal of interest from other signals and noise for subsequent processing (*e.g.,* for filtering and tuning).

A receiver must also perform tuning and frequency translation operations. The atmosphere advantageously supports transmission of RF signals, but not of acoustic signals or of digital baseband signals, over long distances. Consequently, cellular phone signals are transmitted by using baseband signals to vary (*i.e.,* to modulate) some parameter (such as the frequency or phase) of an RF signal thereby translating the baseband signal into the RF range. For example, cellular phone signals may be transmitted at frequencies around 1 GHz. Consequently, upon receiving such a signal, the signal must be translated down to the baseband range before demodulation.

Finally, a receiver must perform filtering operations. In particular, there are typically many signals received at an antenna of a wireless terminal but only one of the received signals is of interest to a subscriber which received signal of interest is typically of much lower power than the other received signals. For example, the antenna of a cellular phone will receive signals over communication paths from a variety of sources including other cellular phones and base stations, and thus a receiver in the cellular phone must filter out all other received signals.

Current cellular receivers typically perform these three operations through use of a receiver architecture known as the superheterodyne receiver architecture. The superheterodyne receiver architecture performs amplification and filtering operations at successive stages where each stage occurs at an intermediate frequency (described below) to which the received signal of interest has been translated. The stages are continued until the received signal interest has been translated down to baseband. *See, e.g.,* Simon Haykin, *Communication Systems* (3rd ed.), John Wiley & Sons, Inc., New York, 1994.

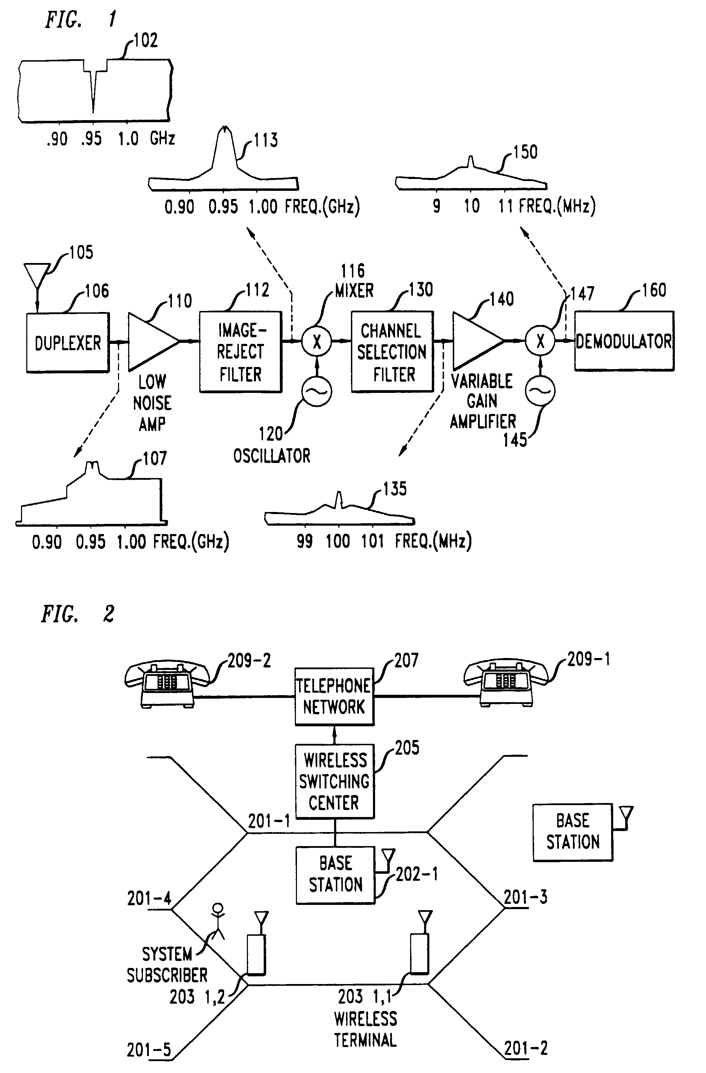

The superheterodyne receiver architecture is illustrated in FIG. 1. The received signal of interest, as well as other signals and noise, are received at antenna 105. For illustrative purposes, the spectrum of signals input to antenna 105 is spectrum 102 comprising a signal of interest centered at .95 GHz. The power in the signal of interest is smaller than the power in other signals received at the antenna Duplexer 106 advantageously acts so as to bandpass filter the signals received at antenna 105. The spectrum of the signal output from duplexer 106 is spectrum 107. The duplexer output signal is amplified in amplifier 110 and is then input to image rejection filter 112 which is designed to eliminate the "image" generation problem.

The image generation problem is inherent with mixing or multiplication operations which are used by receivers to perform frequency translation. The image rejection problem is illustrated as follows. Whenever two signals (for example, a received signal of interest at frequency f1 and a local oscillator signal generated in the receiver at frequency f2*,* where f2>f1) are mixed, the result will be two mixing products, one each at the sum and difference of the two signal frequencies. The mixing products are identical except that one is centered around a frequency of (f1+f2) and the other is centered at a frequency of (f2-f1). For receiving applications, typically it is only required that one of the mixing products be detected. Suppose the mixing product centered at (f2-f1) is desired. The frequency (f2-f1) is also known as an intermediate frequency (IF). Note, however, if a signal at a frequency of (f2+(f2-f1)) is also input to the mixer (*e.g.,* it has not previously been filtered out), the result will be another mixing product also at (f2-f1). The other mixing product, if of sufficient power, will obscure the mixing product at (f2-f1) generated by the signal of interest and the local oscillator. The signal at frequency (f2+(f2-f1)) is a so-called "image signal" to signal of interest f1. Thus, receivers require that signals at the image of the signal of interest (f1) and the local oscillator (f2) be eliminated or rejected.

One class of techniques that exist for performing the image rejection task include the Hilbert transform method and Weaver's method. *See, e.g.,* Haykin, *supra,* and D.K. Weaver, "A Third Method of Generation and Detection of SSB Signals," *Proc. IRE,* pp. 1703-1705, December 1956. Both of these methods, instead of filtering to eliminate image signals as in the superheterodyne receiver architecture, use signal cancellation techniques. In particular, the methods generate signals, equal and opposite to the image signals, and add the created signals to the image signals. The result is cancellation of both the image and created signals, thereby allowing processing of desired signals at an IF.

In the case of Hilbert transform techniques, however, to obtain sufficient image rejection (on the order of 60 dB) it is typically required that tolerances in phase match and amplitude match between the created and image signals be on the order of 0.1° and within .1%, respectively. Such tolerances are difficult and expensive to achieve using integrated circuits. A lower amount of image rejection would be needed if the image signal were caused by an adjacent signal, *e.g.,* by a signal of smaller power such as signals close to the signal of interest in spectrum 102 of FIG. 1. However, it is likewise difficult and expensive to construct components to implement the Hilbert transform technique that will shift the phase of a signal of significant bandwidth uniformly across the bandwidth which is required to accurately execute the Hilbert transform.

In one case of the Weaver method for image rejection, a received RF signal of interest is initially converted first to "dc" (*i.e.* a frequency of zero) by mixing the received RF signal of interest with a local oscillator of the same frequency as a carrier frequency associated with the received RF signal. The resulting signal is then converted to a second, non-zero frequency. However, this method of image rejection typically does not achieve sufficient performance since the method generates a large offset signal at zero frequency (caused by the mixing of the carrier frequency and the local oscillator at the carrier frequency) that typically obscures the signal of interest. In another case, Weaver's method for image rejection converts a received signal of interest to a lower frequency called the first IF and then to an even lower frequency called the second IF. Unfortunately, in the signal environment encountered for cellular systems, such as spectrum 102 of FIG. 1, mixing to such intermediate frequencies typically requires image rejection, again, on the order of 60 dB or more. Such large amounts of image rejection are difficult to achieve due to an inability to accurately match performance characteristics of circuit components. Thus, both the Hilbert transform method and Weaver's method for image rejection are difficult and expensive to implement where the signal of interest is of low power and is surrounded by signals of greater power.

Returning to FIG. 1, the superheterodyne architecture employs a class of techniques for image rejection based on filtering. In particular, the superheterodyne architecture employs image rejection filters, such as image rejection filter 112, so as to attenuate image frequencies prior to the mixing operation thereby ensuring that the only signals present at the IF frequency are those generated by mixing the received signal of interest with the local oscillator. The spectrum of the signal output from image rejection filter 112 is spectrum 113. Next in first mixer 116, the signal is mixed with or translated by a signal generated by first oscillator 120. The output from first mixer 116 is applied to channel selection filter 130. Channel selection filter 130 is a bandpass filter centered around one of the mixing products. The spectrum of the signal output by channel selection filter 130 is spectrum 135. The filtered signal is amplified by variable gain amplifier 140 and mixed in second mixer 147 with a signal generated by second oscillator 145. The mixing, filtering and amplifying operations may be repeated until sufficient amplification and filtering of the signal of interest is achieved at which point the resulting signal (with spectrum 150) is input to demodulator 160, the purpose of which is to recover the signal originally generated by a system subscriber.

Although the superheterodyne architecture may be used to satisfy the requirements for receiver operation even in newly drafted cellular phone standards, the architecture typically requires use of expensive filters such as surface acoustic wave filters for the filtering and tuning operations. Such expensive filters are a significant portion of the cost of circuit components in current cellular receivers.

Thus, as cellular systems seek to increase capacity, the tasks in processing a received signal of interest are made more difficult, and receivers will typically require expensive components to achieve the tasks. Hence, there is a need for improved methods and equipment for receiving signals over a communications path at reduced costs while meeting receiver performance requirements.

### Summary

In accordance with the present invention it is recognized that signals, advantageously used to reject image signals, may be generated when processing a signal of interest by initially translating the signal of interest to a first, non-zero intermediate frequency (IF) and then to a second intermediate frequency higher than the first. In particular, the present invention recognizes signals at frequencies adjacent to or near the signal of interest, although typically larger in power than the signal of interest, are also typically smaller in power than signals not adjacent to or near the signal of interest. The present invention recognizes that if image signals are caused by these frequencies adjacent to or near the signal of interest, a smaller amount of image rejection is required. Moreover, the present invention recognizes that such image rejection is advantageously accomplished by converting to a lower IF first, and then to a higher IF so as to make use of components, such as filters, that can provide sufficient performance at the higher IF at relatively low cost.

In particular, in the inventive method and apparatus an input signal and a first mixing signal are mixed to generate a first signal at a first intermediate frequency, wherein the first intermediate frequency is a non-zero frequency; the first signal is filtered; the filtered first signal and a second mixing signal are mixed to generate a second signal at a second intermediate frequency, wherein the second intermediate frequency is higher than the first intermediate frequency; the input signal and a third mixing signal are mixed to generate a third signal at the first intermediate frequency, wherein the third mixing signal is in quadrature with the first mixing signal; the third signal is filtered; the third filtered signal and a fourth mixing signal are mixed to generate a fourth signal at the second intermediate frequency, wherein the fourth mixing signal is in quadrature with the second mixing signal; and the fourth signal and the second signal are added to generate a summed signal. Image signals in the fourth and second signals are advantageously equal and opposite to each other and cancel each other in the summed signal.

### Brief Description of the Drawings

FIG. 1 illustrates the architecture of a superheterodyne receiver.

FIG. 2 illustrates a wireless communications system.

FIG. 3 is a block diagram of components comprising a wireless terminal.

FIG. 4A illustrates a first spectrum of signals in which a receiver is required to operate under the GSM standard.

FIG. 4B illustrates a second spectrum of signals in which a receiver is required to operate under the GSM standard.

FIG. 5 gives an expanded view of the spectrum of signals in which the receiver is required to operate.

FIG. 6 is a block diagram of the inventive apparatus for receiving a signal.

FIG. 7 illustrates steps in the inventive method for receiving a signal.

FIGs. 8A-8D are plots of example spectra of signals generated by the inventive apparatus.

### Detailed Description

FIG. 2 illustrates a system in which the inventive method and apparatus may be used. In particular, FIG. 2 illustrates a type of wireless communications system called a cellular system. The geographic area serviced by the system is usually partitioned into a number of tessellated areas or cells 201-i. As depicted in the drawing, each cell is represented as a hexagon; in practice, however, each cell typically has an irregular shape that depends on the topology of the geographic area serviced by the system. Within each cell is a respective cell site or base station 202-I. Base station 202-i is advantageously connected, via wireless switching center 205, to wired telephone network 207. Base station 202-i and wireless switching center 205 comprise the wireless infrastructure. Each cell site 202-i establishes wireless communications via radio frequency (RF) comunication paths with wireless terminals 203-i,j operated by system subscribers within the cell for transmitting and receiving information (*e.g.* signals representing data, speech, video, text) from wireless terminals (including those in other cells) and from devices 209-k (*e.g.,* telephones and fax machines) connected to telephone network 207.

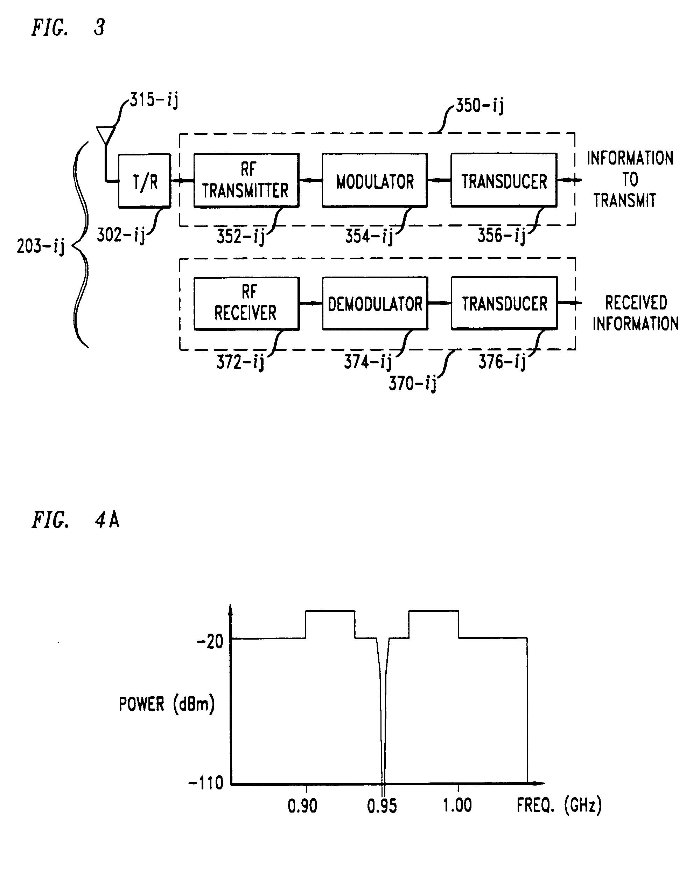

FIG. 3 is a block diagram of components comprising wireless terminal 203-i,j which illustratively herein is a cellular phone for sending and receiving speech signals. Wireless terminal 203-i,j advantageously receives a signal of interest from base station 202-i. Wireless terminal 203-i,j advantageously comprises transmitter 350-i,j and receiver 370-i,j. Transmitter 350-i,j in turn comprises transducer 356-i,j, modulator 354-i,j and RF transmitter 352-i,j. Receiver 370-i,j and transmitter 350-i,j share, via device 302 (*e.g.,* a switch or a duplexer), antenna 315-i,j.

To transmit information, transducer 309-i,j takes a baseband signal, such as speech, and converts it into electrical signals. The electrical signals are input to modulator 354-i,j which uses the electrical signals to vary (*i.e.,* to modulate) some parameter of an RF signal. For example, the GSM standard uses a type of RF modulation called Gaussian Minimum shift key modulation. The modulated RF signal is transmitted along a communications path by RF transmitter 352-i,j over an RF link via antenna 315-i,j. Receiver 370-i,j comprises RF receiver 372-i,j, demodulator 374-i,j and transducer 376-i,j. RF receiver 372-i,j takes the signal of interest at antenna 315-i,j and filters, amplifies and translates the signal so that demodulator 374-i,j may recover an electrical signal representing the variation of a parameter used to modulate the received signal of interest. The demodulator may be either an analog or digital demodulator. The demodulator may use, for example, synchronous or envelope detection techniques depending on the modulation scheme used to transmit the information. The electrical signal is then converted by transducer 376-i,j to an acoustic signal.

Although the wireless infrastructure (*e.g.,* the base stations and the wireless switching centers) and wireless terminals may be manufactured by different entities, they are compatible with each other because they comply with one or more standards which regulate the electromagnetic interface between them (*e.g.,* the Advanced Mobile Phone Service and GSM standards). The tremendous growth of wireless communications in the past few years, as described above, has made adherence to agreed upon standards important.

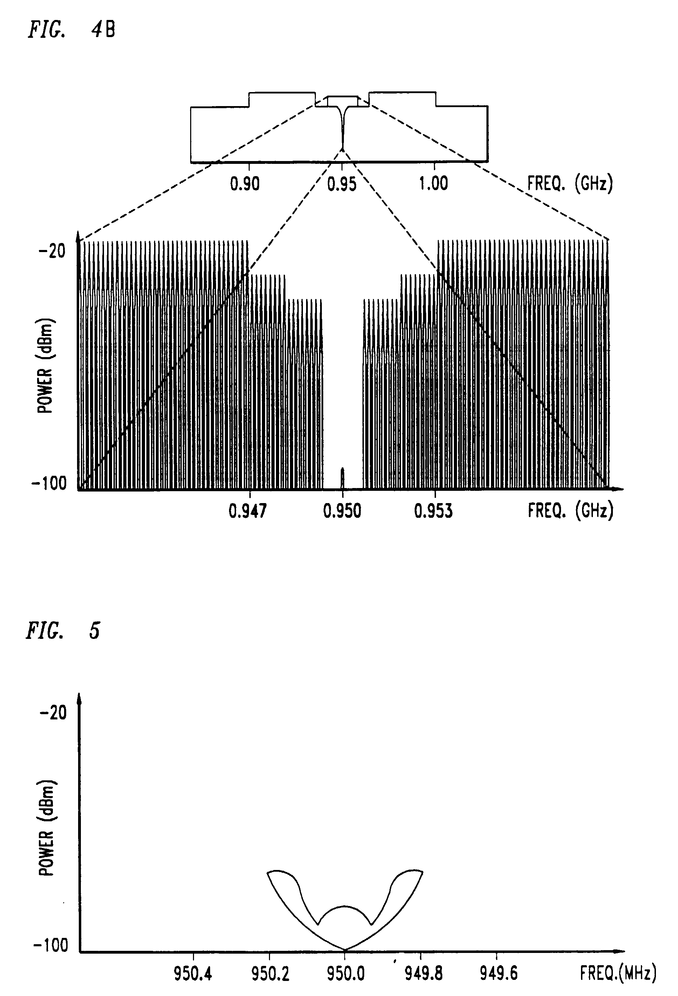

One aspect that is regulated by standards is the performance of receivers of wireless terminals. In particular, the ability of a receiver (*e.g.,* RF receiver 372-i,j) to properly receive a signal of interest (*i.e.,* to take a received signal of interest and to output a baseband signal of satisfactory quality) is specified. Consider, for example, the GSM system for cellular communications in which received signals of interest are in 200 kHz channels associated with carrier frequencies in the frequency range of approximately 0.925- 0.960 GHz, and consider a specific illustrative example in which a received signal of interest is in a 200 kHz channel centered at .95 GHz.. FIG. 4A illustrates an example of one requirement for receiver operation for the illustrative example as specified by the GSM standard (the signals below .90 GHz and above 1.0 GHz have been reduced to reflect filtering such as that performed by device 302 i,j). In this example, the receiver is required to be able to receive a signal of interest on a 200 kHz channel centered at an RF frequency of.950 GHz of power -98 dBm in the presence of signals at other frequencies and power levels as indicated in the figure. FIG. 4B gives an expanded view of the spectrum of FIG. 4A. FIG. 5 illustrates a further receiver requirement under the GSM standard in which a receiver is required to be able to receive a signal of -85 dBm in the presence of signals in adjacent channels as shown. Note that the GSM standard limits the amplitude of the signals in the channels adjacent to the signal of interest to be no more than 9 dB higher than the signal of interest.

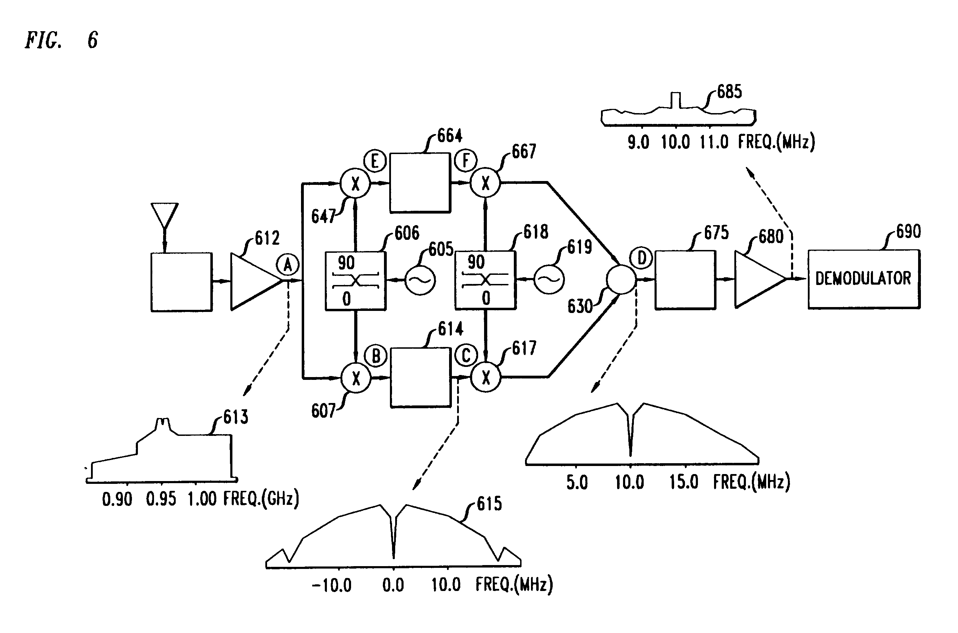

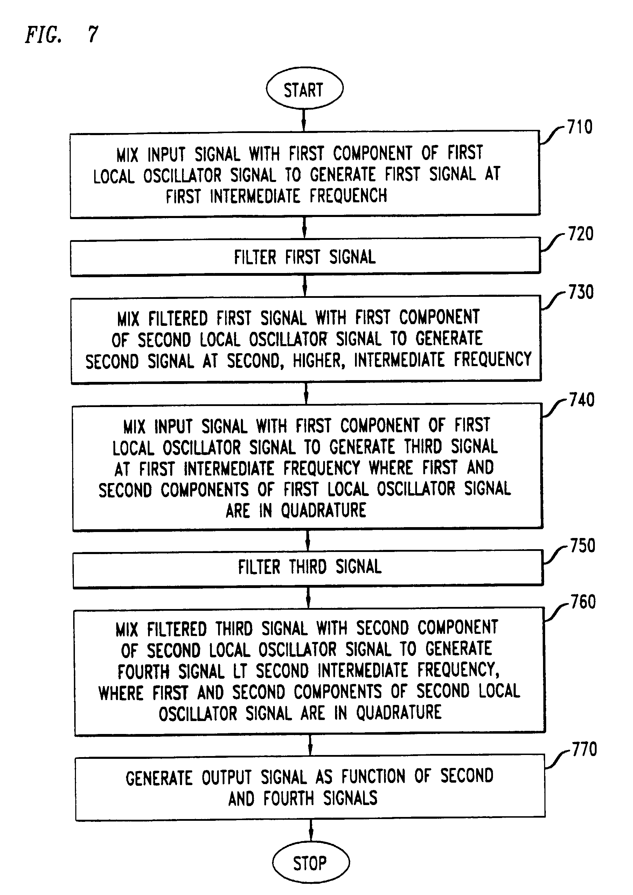

A block diagram of the inventive apparatus for use in RF receiver 372-i,j in the system of FIG. 3 is illustrated in FIG. 6. FIG. 7 illustrates steps in the inventive method, advantageously performed by the inventive apparatus of FIG. 6. The inventive method and apparatus embody the recognition that shortcomings of Weaver's method for image rejection can be overcome. In particular, a received RF signal is translated to a first, non-zero IF frequency and then translated up to a second, higher intermediate frequency. The first IF is, however, advantageously near zero as shown below. In executing the translation, signals are created which advantageously are used to reject image signals caused by the translation operations. Thus, in the inventive method, image rejection is accomplished, and inexpensive filters (such as those mass produced for FM radios) centered around the second IF frequency may be used for channel selection. The inventive method and apparatus advantageously make use of the fact that a signal of interest is received on a carrier frequency in a particular frequency range (between frequencies f _{L} and f _{H}) and that other signals in that range, especially those in channels adjacent to the signal of interest, are typically of limited power, *e.g.* no more than 9 dB higher than the signal of interest in GSM standard, and thus image rejection of these frequencies is readily accomplished.

Turning to FIG. 6, assume that the input to amplifier 612 is the spectrum of FIG. 4A. The spectrum of the signal output from amplifier 612 is spectrum 613. The signal output from amplifier 612 is input to two paths, an upper path from points A to E to F to D2 and a lower path from points A to B to C to D1. The two paths advantageously implement image rejection based on the recognition that the sequence of frequency conversion is not from a first IF frequency to a second, lower IF frequency but instead from a first, non-zero IF frequency to a higher IF frequency.

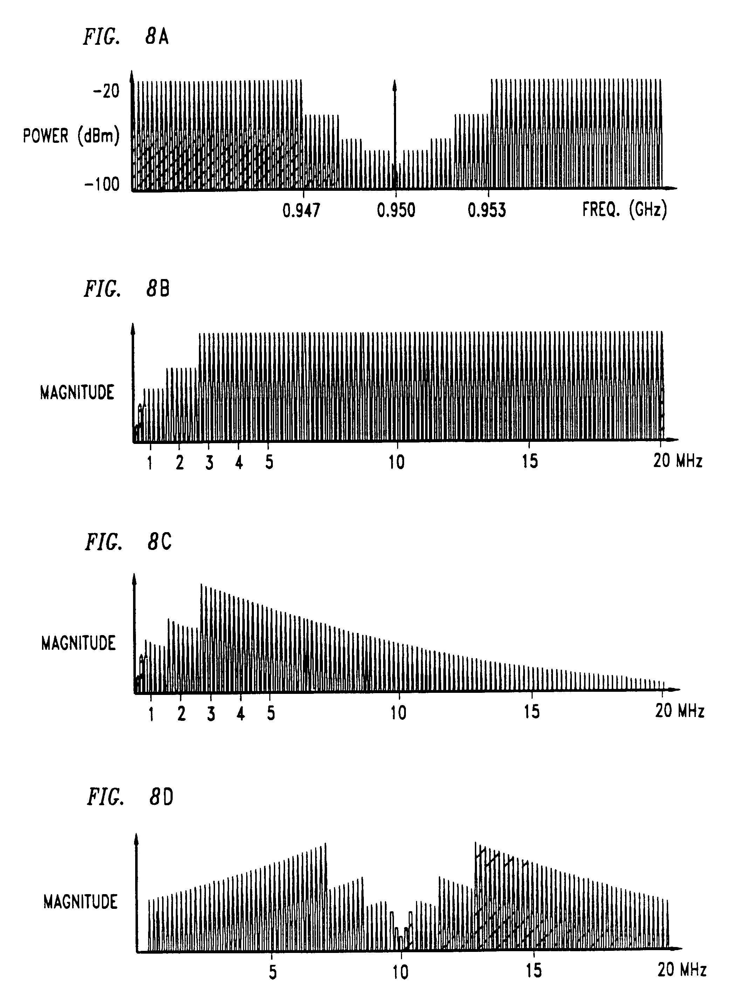

Consider first operations along path A to D1. In step 710, the signal output from amplifier 612 is first mixed in first mixer 607 with a first mixing signal. The first mixing signal advantageously is a signal output from first phase splitter 606. First phase splitter 606 splits a signal, input from first local oscillator 605, into a first component and a second component where the components are in quadrature, *i.e.,* the phase of one of the components is *n*(360°) ± 90° for n=0, ±1, ±2, ±3, . . ., relative to the phase of the other component. For convenience herein, the components may be regarded as sine and cosine waves where the cosine wave may be described as lagging the sine was by 90 degrees in phase. In this example, the signal from first local oscillator 605 is at a frequency of 949.9 MHz, *i.e.* at frequency in between the channel adjacent to the signal of interest and the signal of interest itself. Assume for illustrative purposes that the lagging component (*i.e.* the cosine wave component) is input to first mixer 607. The two signals input to first mixer 607 are illustrated FIG. 8A (which shows only the positive frequency axis). As noted above, a mixing operation yields two mixing products. Filter 614 advantageously selects the mixing product at lower frequencies in step 720. Filter 614 is also a dc-blocking filter, *i.e.* the filter greatly attenuates signals at dc thereby eliminating any dc components caused by self-mixing of the local oscillator (caused by the local oscillator signal feeding through to the antenna and being reflected back due to mismatches in circuit components). The spectrum of the signal output from filter 614 is spectrum 615 which is illustrated in greater detail in FIG. 8B. Note that the spectrum of interest, *i.e.* the spectrum that is shaded, is obscured by an over lapping spectrum (the spectrum marked with hatch marks) resulting from mixing products in the same frequency range (and thus not filtered out by filter 614).

In step 730 the signal output from filter 614 next mixed in second mixer 617 with a second mixing signal. The second mixing signal advantageously is a signal output from second phase splitter 618. Second phase splitter 618 splits a signal input from second local oscillator 619 into a first component and a second component where the phase of the components are in quadrature. For convenience, the components may be regarded as negative sine and cosine waves where the negative sine wave may be described as lagging the cosine was by 90 degrees in phase. The signal from second local oscillator 619 is illustratively at a frequency of either 10.6 or 10.8 Mhz. Assume the cosinge wave component is input to second mixer 617. The two signals input to second mixer 617 are illustrated FIG. 8C. The output of second mixer 617 is input to system 630 at point D1.

At this point is advantageous to consider operations along the path A to E to F to D2. In step 740 the signal output from amplifier 612 along path A to E to F to D is first mixed in third mixer 647 with a third mixing signal. Third mixing signal advantageously is a component output from first phase splitter 606. Recall that first phase splitter 606 splits a signal input from first local oscillator 605 into two components where the phases of the components are in quadrature . The component not input to first mixer 607 from first phase splitter 606 is input to third mixer 647, *i.e.* consistent with the choice of signal component input to mixer 607 above, in this example the leading or sine component is input to third mixer 647. The resulting spectrum of the signal output from third mixer 647 is the same as the spectrum output from first mixer 607 but with amplitudes of negative frequency components inverted. Filter 664 advantageously selects the mixing product at lower frequencies in step 750. Filter 664 is also advantageously a dc-blocking filter.

In step 760 the signal output from low pass filter 664 next mixed in fourth mixer 667 with a fourth mixing signal. The fourth mixing signal advantageously is a signal output from second phase splitter 618. In this example, the signal output from second phase splitter 618 is the lagging or negative sine component of second local oscillator 619. The signal from second local oscillator 619 is at a frequency of either 10.6 or 10.8 MHz. The output of mixer 667 is input to system 630 at point D2 in step 770. System 630 (which, for example, may comprise a summer) then advantageously generates an output signal as a function of the signal output from mixer 607 and the signal output from mixer 667.

Thus, the input to system 630 advantageously is two signals whose spectra are such that the components representing the signal of interest are in phase but where the components representing image signals are 180° out of phase so that when the signals are summed together the result is simply the signal of interest. Moreover, as shown in FIG. 8D, the resulting signal is centered at 10.7 MHz, a frequency at which high performance, passive and inexpensive filters are available for use as filter 675. Such filters are available, in part, due to the demand for filters in this frequency range for use in receiving FM broadcast signals in devices such as car radios and home stereos. The spectrum of the output signal, after bandpass filtering through filter 675 and amplification in amplifier 680, is spectrum 685. The output of filter 680 is then input to demodulator 690 to recover the baseband signal used to modulate to the received signal.

The method and apparatus disclosed herein have been described without reference to specific hardware or software. Instead the method and apparatus have been described in such a way that those skilled in the art can readily adapt such hardware or software as may be available or preferable. While the above teaching of the inventive method and apparatus has been in the context of transmitting speech signals via a cellular phone system, those skilled in the art will recognize the applicability of these teaching to other contexts. For example, other information signals, such a video signals, may be transmitted. Also, the inventive method and apparatus are not limited to processing received signals of interest according to the GSM standard. Signals compatible with other cellular and wireless standards, such as the IS-96 and IS-136 standards, may also be processed using the inventive method and apparatus using appropriate detectors to recover baseband signals. The inventive method and apparatus may be used for wireless communications applications, other than cellular phone applications, such as FSK (frequency shift key) and DQPSK (differential quadriphase shift keying) transmission. Moreover, the inventive method and apparatus may be used for paths for wired RF communication applications such as cable television systems.

## Claims

1. A method comprising the steps of:
mixing an input signal and a first mixing signal to generate a first signal at a first intermediate frequency, wherein said first intermediate frequency is a non-zero frequency,
filtering said first signal,
mining the filtered first signal and a second mixing signal to generate a second signal at a second intermediate frequency, wherein said second intermediate frequency is higher than said first intermediate frequency,
mixing said input signal and a third mixing signal to generate a third signal at said first intermediate frequency, wherein said third mixing signal is in quadrature with said first mixing signal,
filtering said third signal,
mixing the third filtered signal and a fourth mixing signal to generate a fourth signal at said second intermediate frequency, wherein said fourth mixing signal is in quadrature with said second mixing signal, and
generating an output signal as a function of said fourth signal and said second signal.

2. The method of claim 1 wherein said first mixing signal is a first component of a first local oscillator signal and said third mixing signal is a second component of said first local oscillator signal, wherein said first component and said second component are generated by the step of:
phase splitting said first local oscillator signal to generate said first component and said second component, wherein said second component of said first oscillator signal is in quadrature with said first component of said first oscillator signal.

3. The method of claim 1 wherein said second mixing signal is a first component of a second local oscillator signal and said fourth mixing signal is a second component of said second local oscillator signal, wherein said first component and said second component are generated by the step of:
phase splitting said second local oscillator signal to generate said first component and said second component, wherein said second component of said second oscillator signal is in quadrature with said first component of said second oscillator signal.

4. In a wireless communications system, a method of processing an input signal in a wireless terminal, said method comprising the steps of:
applying said input signal and a first component of a first local oscillator signal to a first mixer to generate a first signal at a first intermediate frequency, wherein said first intermediate frequency is non-zero frequency,
applying said first signal to a first filter,
applying the filtered first signal and a first component of a second local oscillator signal to a second mixer to a second signal at a second intermediate frequency, wherein said second intermediate frequency is higher than said first intermediate frequency,
applying said input signal and a second component of said first local oscillator signal to a third mixer to generate a third signal at said first intermediate frequency, wherein said second component of said first oscillator signal is in quadradure with said, first component of said first oscillator signal,
applying said third signal to a second filter,
applying the third filtered signal and a second component of said second local oscillator signal to a fourth mixer to generate a fourth signal at said second intermediate frequency, wherein said second component of said second oscillator signal is in quadrature with said first component of said second oscillator signal, and
generating an output signal as a function of said fourth signal and said second signal.

5. The method of claim 1 or 4 further comprising the step of:
bandpass filtering said output signal.

6. The method of claim 1 or 4 wherein said first filter comprises a dc blocking filter and a low pass filter wherein said low pass filter has a cutoff frequency above the frequency of said first intermediate frequency.

7. The method of claim 1 or 4 wherein said second filter comprises a dc blocking filter and a low pass filter wherein said low pass filter has a cutoff frequency above the frequency of said first intermediate frequency.

8. The method of claim 1 or 4 wherein said input signal is generated by the step of: receiving a signal over a communications path.

9. The method of claim 8 wherein said input signal is further generated by the steps of:
filtering the received signal, and
amplifying said received signal to generate said input signal.

10. The method of claim 4 wherein said first component of said first local oscillator signal and said second component of said first local oscillator signal are generated by the step of:
phase splitting said first local oscillator signal to generate said first component and said second component, wherein said second component of said first oscillator signal is in quadrature with said first component of said first oscillator signal.

11. The method of claim 4 wherein said first component of said second local oscillator signal and said second component of said second local oscillator signal are generated by the step of:
phase splitting said second local oscillator signal to generate said first component and said second component, wherein said second component of said second oscillator signal is in quadrature with said first component of said second oscillator signal.

12. The method of claim 1 or 4 wherein said input signal has an associated carrier frequency, wherein said associated carrier frequency is of a given frequency in a range of carrier frequencies between f_{L} and f_{H}, wherein f_{L} is the lowest carrier frequency in said range and f_{H} is the highest frequency in said range, and wherein said first intermediate frequency is of a frequency less than half of the difference between fH and fL.

13. The method of claim 1 or 4 wherein said first intermediate frequency is of a frequency equal to half the difference between the frequency of a carrier frequency associated with said input signal and the frequency of a carrier frequency associated with another signal having an associated power level wherein said associated power level of said other signal is related to the power level of said input signal.

14. The method of claim 1 or 4 wherein said first intermediate frequency is of a frequency equal to half the difference between the frequency of a carrier frequency associated with said input signal and the frequency of a carrier frequency associated with another signal wherein said other signal is in a channel adjacent to said input signal.

15. The method of claim 1 or 4 wherein said second intermediate frequency is of a frequency of 10.6-10.8 Mhz.

16. A system comprising:
a first mixer for mixing an input signal and a first component of a first local oscillator signal to generate a first signal at a first intermediate frequency, wherein said first intermediate frequency is a non-zero frequency,
a first filter for filtering said first signal,
a second mixer for mixing the filtered first signal and a first component of a second local oscillator signal to generate a second signal at a second intermediate frequency, wherein said second intermediate frequency is higher than said first intermediate frequency,
a third mixer for mixing said input signal and a second component of said first local oscillator signal to generate a third signal at said first intermediate frequency, wherein said second component of said first oscillator signal is in quadrature with said first component of said first oscillator signal,
a second filter for filtering said third signal,
a fourth mixer for mixing the third filtered signal and a second component of said second local oscillator signal to generate a fourth signal at said second intermediate frequency, wherein said second component of said second oscillator signal is in quadrature with said first component of said second oscillator signal, and
an output system for generating an output signal as a function of said fourth signal and said second signal.

17. The system of claim 16 wherein said output system comprises a summer.

18. The system of claim 16 further comprising:
a bandpass filter for filtering said output signal.

19. The system of claim 16 wherein said first filter comprises a dc blocking filter and a low pass filter wherein said low pass filter has a cutoff frequency above the frequency of said first intermediate frequency.

20. The system of claim 16 wherein said second filter comprises a dc blocking filter and a low pass filter wherein said low pass filter has a cutoff frequency above the frequency of said first intermediate frequency.

21. The system of claim 16 further comprising:
an antenna for receiving a signal over a communications path.

22. The system of claim 21 further comprising:
a filter for filtering the received signal, and
an amplifier for amplifying said received signal to generate said input signal.

23. The system of claim 16 further comprising:
a phase splitter for generating said first component and said second component of said first local oscillator signal, wherein said second component of said first local oscillator signal is in quadrature with said first component of said first oscillator signal.

24. The system of claim 16 further comprising:
a phase splitter for generating said first component and said second component of said second local oscillator signal, wherein said second component of said second local oscillator signal is in quadrature with said first component of said second oscillator signal.

25. The system of claim 16 wherein said input signal has an associated carrier frequency, wherein said associated carrier frequency is of a given frequency in a range of carrier frequencies between f_{L} and f_{H}, wherein f_{L} is the lowest carrier frequency in said range and f_{H} is the highest frequency in said range, and wherein said first intermediate frequency is of a frequency less than half of the difference between f_{H} and f_{L}.

26. The system of claim 16 wherein said first intermediate frequency is of a frequency equal to half the difference between the frequency of a carrier frequency associated with said input signal and the frequency of a carrier frequency associated with another signal having an associated power level wherein said associated power level of said other signal is related to the power level of said input signal.

27. The system of claim 16 wherein said first intermediate frequency is of a frequency equal to half the difference between the frequency of a carrier frequency associated with said input signal and the frequency of a carrier frequency associated with another signal wherein said other signal is in a channel adjacent to said input signal.

28. The system of claim 16 wherein said second intermediate frequency is of a frequency of 10.6-10.8 Mhz.
